# FASCICULE DE BREVET EUROPEEN

(11) **EP 0 843 412 B1**
(45) Date de publication et mention de la délivrance du brevet: **02.05.2003**
(21) Numéro de dépôt: 97402727.8
(22) Date de dépôt: 14.11.1997
(51) Int. Cl.: H03K 17/945

(54) **Détecteur de proximité à source de courant stable**
Anwesenheitsdetektor mit einer stabilisierten Stromquelle
A proximity detector with a stable current source

(30) Priorité: 18.11.1996 FR 9614123
(43) Date de publication de la demande: 20.05.1998
(73) Titulaire: Schneider Electric Industries SAS, 92500 Rueil-Malmaison (FR)
(72) Inventeur: Charrier, Pierre, Ing., 86440 Migne-Auxances (FR); Tardivon, Alain, Ing., 16170 Rouillac (FR)

(56) Documents cités:
- GB-A- 2 219 862
- GB-A- 2 262 998
- US-A- 4 344 071

## Description

La présente invention concerne un détecteur de proximité du type à deux bornes susceptibles d'être reliées à un circuit de charge qui comprend une charge mise en série avec une source externe d'alimentation électrique en tension alternative ou continue, de manière que cette source soit en mesure d'alimenter la charge et le détecteur.

Le document GB-A 2 262 998 divulgue un détecteur de ce type.

De tels détecteurs comprennent généralement d'une part un organe détecteur inductif, capacitif, photoélectrique, etc.. auquel est associé un circuit électronique de traitement apte à délivrer un signal de commutation en réponse à l'approche ou à la présence d'un objet ou cible et d'autre part un interrupteur électronique de puissance connecté aux bornes du détecteur pour déterminer l'ouverture et la fermeture du circuit de charge. L'interrupteur est commandé par le signal de commutation de façon à être bloqué dans l'état ouvert du détecteur et à être passant dans l'état fermé du détecteur.

Pour alimenter les circuits électroniques du détecteur, on prévoit une source de courant qui doit fonctionner quand le détecteur est ouvert Le courant alors délivré par la source doit être faible et stable quelles que soient les conditions de tension d'alimentation et de température. De plus, même quand le détecteur est fermé, il lui faut présenter une tension de déchet qui doit rester faible et bien maîtrisée quel que soit le courant commuté traversant l'interrupteur de puissance et qui doit varier peu avec la température.

L'invention a pour but de rendre stable et précise la source de courant d'un détecteur à deux bornes du type décrit, tout en conservant au détecteur un caractère peu onéreux.

Selon l'invention, la source de courant comprend
- un transistor du type MOS dont le chemin drain-source appartient, dans l'état fermé du détecteur, à un chemin de conduction qui relie une borne du détecteur à une entrée de pilotage de l'interrupteur de puissance,
- un étage régulateur couplé au premier transistor pour le maintenir saturé dans l'état fermé du détecteur et réguler sa tension de grille dans l'état ouvert du détecteur,
- l'étage régulateur comprenant deux transistors bipolaires de préférence appairés dans un seul et même boîtier, dont l'un a sa base reliée à la source du transistor MOS via un élément de référence de tension et dont le chemin principal relie la grille du transistor MOS à une sortie de la source de courant, et dont l'autre relie la source du transistor MOS à ladite sortie via une résistance de référence. Il est avantageux de pouvoir utiliser dans le détecteur conforme à l'invention, particulièrement au niveau de sa source de courant, des circuits électroniques discrets.

La description qui suit d'un exemple de réalisation de l'invention , en regard des dessins annexés, permettra de bien comprendre les caractéristiques de l'invention et les résultats qu'elle autorise.

La figure 1 représente schématiquement la conception électrique du détecteur selon l'invention.

La figure 2 montre plus en détail une partie du schéma du détecteur de la figure 1.

Le détecteur de proximité 10 illustré sur les figures est du type à deux homes B1,B2, susceptibles d'être reliées par des fils respectifs 11,12 à une charge L disposée en série avec une source d'énergie électrique 13. Cette source 13 est prévue pour alimenter le détecteur, que celui-ci soit ouvert ou fermé, ainsi que la charge ; elle peut être une source de tension continue ou alternative, le détecteur présentant en effet à son entrée un pont redresseur double alternance 14.

Le détecteur de proximité comprend un organe détecteur 20, un interrupteur électronique de puissance à transistor 30 et un dispositif 40 de commande de l'interrupteur et de contrôle d'alimentation. L'organe détecteur est de type inductif, capacitif, photoélectrique, etc.., apte à fournir un signal S de commutation en réponse à l'approche ou à la présence d'un objet ou d'une cible K; l'interrupteur électronique de puissance 30 est disposé sur un conducteur 31 qui relie les bornes de tension continue 15,16 du pont redresseur 14, par exemple au moyen d'une branche haute 31a au potentiel V et d'une branche basse 31b au potentiel 0V, et il est assujetti à un interrupteur pilote 41 du dispositif 40. A l'organe détecteur 20 est associé un circuit électronique de traitement non représenté.

Le dispositif 40 comporte en outre une source de courant continu 42 et un circuit élévateur de tension 43.

La source de courant 42 est connectée entre la branche haute 31a du conducteur 31, c'est-à-dire la borne 15 du pont 14, et le circuit élévateur de tension 43, auquel elle est reliée via une diode D1 ; elle présente un organe régulateur 44 constitué selon l'invention par un transistor MOS à déplétion T1, qui permet de s'adapter à une large plage de tensions d'alimentation, par exemple de 20V à 264V, et un étage régulateur 45 qui coopère avec T1. Le drain du transistor T1 est relié à la branche 31a du conducteur 31 et sa source A est reliée à l'étage régulateur 45 et à une borne principale de l'interrupteur pilote 41, dont l'autre borne principale est reliée à une entrée E du circuit élévateur 43. L'interrupteur 41 est par exemple un transistor MS T2.

Quand le détecteur est au repos ( état ouvert ou "non commuté" ), T2 est bloqué et le courant I1 qui traverse le transistor T1 est acheminé via l'étage régulateur 45 et une diode D1 vers une entrée F du circuit élévateur 43 ; quand le détecteur est activé ( état fermé ou "commuté" ), T2 est passant et achemine un courant I2 vers l'entrée E du circuit 43, celui-ci délivrant une tension plus élevée en H qu'en E. La tension engendrée par le circuit 43 à sa sortie H est appliquée à l'organe détecteur 20 et notamment à son circuit électronique. Le signal de commande de l'interrupteur de puissance 30 est délivré par la sortie J du circuit élévateur.

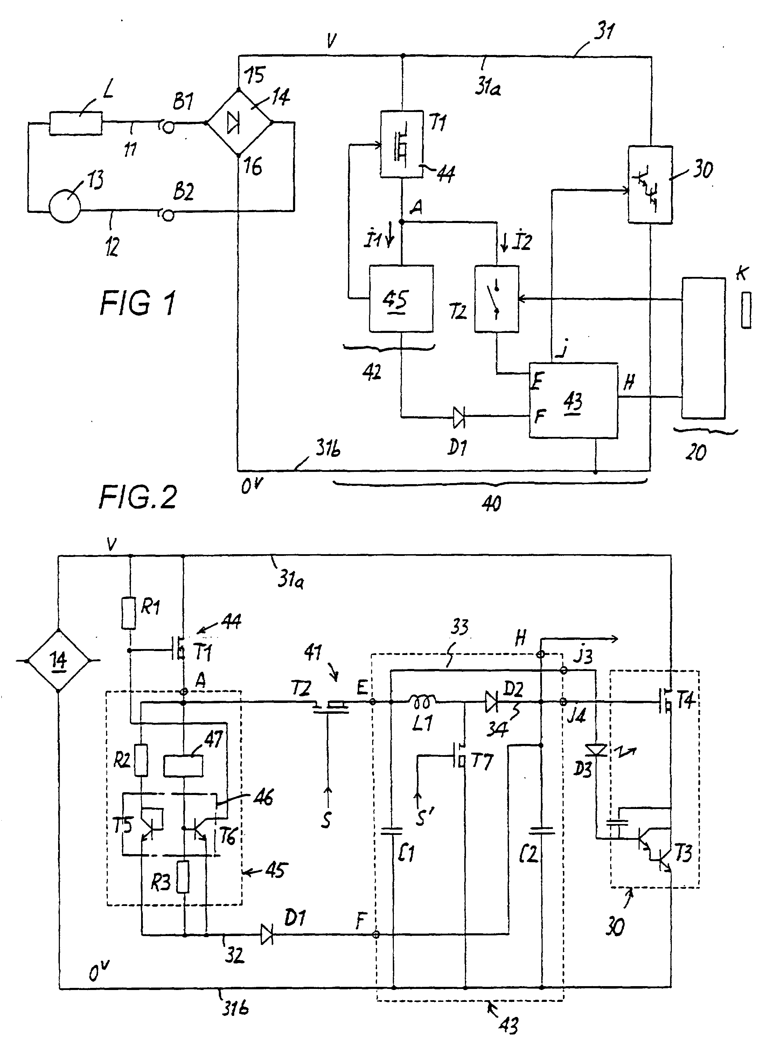

On a représenté sur la figure 2 une partie du détecteur schématisé sur la figure 1, de manière à mieux montrer la constitution de l'étage régulateur 45 et du circuit élévateur de tension 43 et leur relation avec les autres constituants. Il convient de noter que l'interrupteur de puissance 30 est formé par un montage Darlington T3 cascodé avec un transistor MOS T4. Le transistor MOS à déplétion T1, constitué comme T4 par un composant haute tension peu encombrant, a son drain relié à la branche 31a et sa grille reliée également à la branche 31a via une résistance R1 de polarisation de grille. Le point A auquel se raccorde la source de T1 est relié d'une part via une résistance de référence R2 au collecteur d'un transistor bipolaire T5 à bouclage base-collecteur dont l'émetteur est relié à un conducteur 32 connecté à l'anode de la diode D1 ; d'autre part, le point A est relié via un élément de référence de tension 47, par exemple un circuit actif ou une diode Zener, à la base d'un transistor bipolaire T6 et via une résistance R3 au conducteur 32. Il est avantageux que les transistors T5,T6 appartiennent à un même composant, en étant appairés tous deux dans un même boîtier 46, par exemple de type SOT 363.

Le circuit élévateur 43 présente une inductance L1 reliée d'un côté à l'entrée E du circuit qui est reliée à T2 et via une capacité C1 à la branche 31b ; de l'autre côté, l'inductance L1 est reliée d'une part à l'anode d'une diode D2 dont la cathode est reliée en sortie J4 du circuit 43 à la grille du transistor MOS T4 et d'autre part au drain d'un transistor MOS T7 de mise en oeuvre de l'élévateur ; la grille de T7 est sollicitée par un signal logique S' délivré par une horloge et sa source est mise au potentiel bas de 31b. La cathode de D1 est reliée au point H, lui-même relié par une capacité C2 au potentiel bas de 31b. Enfin, le point E est raccordé en sortie J3 du circuit 43 à la base du transistor Darlington T3 par un conducteur 33 comprenant une diode électroluminescente D3.

Le détecteur décrit fonctionne de la manière suivante.

A l'état ouvert du détecteur (non commuté), le signal S bloque le transistor pilote T2 et le signal S' bloque T7. Le transistor T1 est passant et le courant I qui le traverse et qui traverse majoritairement R2 et T5 reste constant puisque le transistor T6 régule la tension grille de T1. T5 compense la chute de tension dans T6. Le courant traversant le circuit de référence de tension 47 et R3 est faible par rapport à celui qui circule dans R2 et T5. Le courant constant et stable I est acheminé via D1 vers le point H pour alimenter l'organe détecteur.

A l'état fermé du détecteur (commuté), le signal S rend passant le transistor T2 et le signal d'horloge S' est actif et permet d'exciter T7. Comme T2 est passant, les transistors T5 et T6 sont bloqués et T1 se retrouve saturé. La chute de tension dans les transistors T1 et T2 est faible et le courant qui les traverse pilote l'interrupteur de puissance 30 par les sorties J3,J4 du circuit 43, plus précisément via un conducteur 33 reliant le point E à la base du Darlington T3 et via le conducteur 34 reliant la cathode de D2 à la grille de T4. La tension de déchet du détecteur reste faible et sous forme de tension alternative carrée.

La source de courant décrite a plusieurs avantages. Elle peut fonctionner aussi bien sous très faible tension que sous forte tension grâce à l'étage régulateur 45. Les transistors T5,T6 de l'étage 45, appairés dans un même boîtier de composant, rendent la source de courant très précise et stable, notamment en fonction de la température.

## Revendications

1. Détecteur de proximité du type à deux bornes susceptibles d'être reliées à un circuit de charge qui comprend une source externe d'alimentation électrique en série avec une charge, lequel détecteur comporte un organe détecteur (20) apte à délivrer un signal de commutation (S) en réponse à la présence ou à l'approche d'un objet, un interrupteur électronique de puissance (30) disposé sur un conducteur reliant entre elles les bornes et commandable par le signal de commutation pour être bloqué dans un état dit ouvert du détecteur et pour être passant dans un état dit fermé du détecteur et une source de courant continu (42) connectée du côté entrée à l'une des bornes et du côté sortie à l'organe détecteur pour alimenter celui-ci en courant quel que soit l'état du détecteur,
**caractérisé par le fait que** la source de courant continu (42) comprend :
- un transistor (T1) du type MOS dont le chemin drain-source appartient, dans l'état fermé du détecteur, à un chemin de conduction reliant une borne (15) du détecteur à une entrée de pilotage de l'interrupteur de puissance (30),
- un étage régulateur (45) couplé au transistor MOS (T1) pour le maintenir saturé dans l'état fermé du détecteur et pour réguler sa tension de grille dans l'état ouvert du détecteur,
- l'étage régulateur (45) comprenant un premier transistor bipolaire (T6) dont la base est reliée à la source (A) du transistor MOS (T1) via un élément de référence de tension (47) et dont le chemin principal relie la grille du transistor MOS à une sortie de la source de courant, et un deuxième transistor bipolaire (T5) dont le chemin principal relie la source (A) du transistor MOS à ladite sortie via une résistance de référence (R2).

2. Détecteur de proximité selon la revendication 1, **caractérisé par le fait que** les deux transistors bipolaires (T5,T6) sont appairés dans un même boîtier de composant (46).

3. Détecteur de proximité selon la revendication 1, **caractérisé par le fait que** le chemin drain-source du transistor MOS (T1) est relié à l'entrée de pilotage de l'interrupteur de puissance (30) en parallèle par l'étage régulateur (45) et par un interrupteur pilote (T2) apte à commander l'interrupteur de puissance (30) et sollicité par le signal de commutation (S).

4. Détecteur de proximité selon la revendication 3, **caractérisé par le fait que** l'interrupteur pilote (T2) est relié à l'interrupteur de puissance (30) via un circuit élévateur de tension (43) comprenant un interrupteur (T7) dont la mise en oeuvre est assujettie à un signal d'horloge (S') mis en oeuvre selon l'état du signal de commutation (S).

5. Détecteur de proximité selon la revendication 1, **caractérisé par le fait que** l'interrupteur de puissance (30) est à transistors et que le transistor MOS (T1) est du type à déplétion.

## Patentansprüche

1. Näherungsdetektor des Typs mit zwei Klemmen dazu geeignet, an einen Lastkreis geschaltet zu werden, der eine außenstehende mit einer Last gereihten Stromversorgungsquelle umfasst, wobei der Detektor ein Detektororgan (20), das in der Lage ist, ein Schaltsignal (S) als Reaktion auf die Anwesenheit oder Annäherung eines Gegenstandes abzugeben, einen elektronischen Leistungsschalter (30) welcher auf einem zwei Klemmen zusammenschaltenden und vom Schaltsignal steuerbaren Leiter angeordnet ist, um bei der sogenannten offenen Stellung des Detektors nichtleitend und bei der sogenannten geschlossenen Stellung des Detektors leitend zu sein, und eine Gleichstromquelle (42), die eingangsseitig an eine der Klemmen und ausgangsseitig an das Detektororgan geklemmt ist, um dieses unabhängig von der Stellung des Detektors mit Strom zu versorgen, umfasst,
**dadurch gekennzeichnet, dass** die Gleichstromquelle (42) folgendes umfasst:
- einen Transistor (T1) des MOS Typs, dessen Abfluss-Quellenweg bei geschlossener Stellung des Detektors einem Leiterweg angehört, der eine Klemme (15) des Detektors an den Steuerungseingang des Leistungsschalters (30) schaltet,
- eine mit dem MOS Transistor (T1) gekoppelte Regulierungsstufe (45), damit er bei geschlossener Stellung des Detektors gesättigt bleibt und um seine Gitterspannung bei geöffneter Stellung des Detektors zu regulieren,
- die Regulierungsstufe (45), die einen ersten bipolaren Transistor (T6) aufweist, dessen Base über ein Bezugsspannungselement (47) an die Quelle (A) des MOS Transistors (T1) geschaltet ist und dessen Hauptweg das Gitter des MOS Transistors an einen Ausgang der Stromquelle schaltet und einen zweiten bipolaren Transistor (T5), dessen Hauptweg die Quelle (A) des MOS Transistors an den besagten Ausgang über einen Bezugswiderstand (R2) schaltet.

2. Näherungsdetektor nach Anspruch 1, **dadurch gekennzeichnet, dass** die bipolaren Transistoren (T5, T6) in einem einzigen Gehäusebauteil (46) gepaart sind.

3. Näherungsdetektor nach Anspruch 1, **dadurch gekennzeichnet, dass** der Abfluss-Quellenweg des MOS Transistors (T1) an den Steuerungseingang des Leistungsschalters (30) durch die Regulierungsstufe (45) und durch einen Steuerungsschalter (T2) parallel geschaltet ist, der in der Lage ist, den Leistungsschalter (30) zu steuern und vom Schaltsignal (S) beansprucht wird.

4. Näherungsdetektor nach Anspruch 3, **dadurch gekennzeichnet, dass** der Steuerungsschalter (T2) an den Leistungsschalter (30) über einen Spannungserhöhungskreis (43) mit einem Schalter (T7), dessen Bewegung dem Uhrensignal (S') untergeordnet ist, welches wiederum je nach Stellung des Schaltsignals (S) in Bewegung gesetzt wird.

5. Näherungsdetektor nach Anspruch 1, **dadurch gekennzeichnet, dass** der Leistungsschalter (30) ein Transistorschalter ist und dass der MOS Transistor (T1) des Verarmungs-Typs ist.

## Claims

1. A proximity detector of the type with two terminals able to be connected to a charging circuit which includes an external electrical power source in series with a load, the detector including a detector unit (20) capable of delivering a switch signal (S) in response to the presence or the approach of an object, an electronic power switch (30) arranged on a conductor connecting the terminals to one another and which can be commanded by the switch signal to be off in a condition of the detector referred to as open and to be on in a condition of the detector referred to as closed and a source of direct current (42) connected on the input side to one of the terminals and on the output side to the detector unit in order to supply it with current whatever the condition of the detector,
**characterised in that** the direct current source (42) includes:
- an MOS type transistor (T1) whose drain-source path, in the closed condition of the detector, forms part of a conduction path linking a terminal (15) of the detector to a control input for the power switch (30),
- a regulator stage (45) coupled to the first transistor in order to keep it saturated in the closed condition of the detector and to regulate its gate voltage in the open condition of the detector,
- the regulator stage (45) including a first bipolar transistor (T6) whose base is connected to the source (A) of the MOS transistor (T1) via a reference voltage device (47) and whose main path connects the gate of the MOS transistor to an output of the current source, and a second bipolar transistor (T5) whose main path connects the source (A) of the MOS transistor to said output via a reference resistance (R2).

2. A proximity detector according to Claim 1, **characterised in that** the two bipolar transistors (T5, T6) are paired in one and the same component package (46) .

3. A proximity detector according to Claim 1, **characterised in that** the drain-source path of the MOS transistor (T1) is connected in parallel to the power switch (30) control input through the regulator stage (45) and through a control switch (T2) capable of commanding the power switch (30) and actuated by the switch signal (S).

4. A proximity detector according to Claim 3, **characterised in that** the control switch (T2) is connected to the power switch (30) through voltage increasing circuit (43) including a switch (T7) whose operation is fixed to a clock signal (S') operated in accordance with the state of the switch signal (S).

5. A proximity detector according to Claim 1, **characterised in that** the power switch (30) is a transistor switch and that the MOS transistor (T1) is a depletion type transistor.
